# EUROPEAN PATENT SPECIFICATION

(11) **EP 1 053 510 B1**
(45) Date of publication and mention of the grant of the patent: **22.01.2003**
(21) Application number: 99907390.1
(22) Date of filing: 20.01.1999
(51) Int. Cl.: G03F 7/023

(54) **PROCESS FOR PRODUCING A PHOTORESIST COMPOSITION HAVING A REDUCED TENDENCY TO PRODUCE PARTICLES**
VERFAHREN ZUR HERSTELLUNG EINER PHOTORESISTZUSAMMENSTELLUNG MIT VERRINGERTER NEIGUNG ZUR BILDUNG VON TEILCHEN
PROCEDE DE PRODUCTION D'UN AGENT PHOTORESISTANT MOINS ENCLIN A PRODUIRE DES PARTICULES

(30) Priority: 02.02.1998 US 17083
(43) Date of publication of application: 22.11.2000
(73) Proprietor: Clariant Finance (BVI) Limited, Road Town, Tortola (VG)
(72) Inventor: OBERLANDER, Joseph, E., Phillipsburg, NJ 08865 (US); RAHMAN, M., Dalil, Flemington, NJ 08822 (US); COOK, Michelle, M., Somerville, NJ 08876 (US); NELSON, William, C., Whitehouse Station, NJ 08889 (US)
(74) Representative: Hütter, Klaus, Dr.
(86) International application number: EP9900343
(87) International publication number: WO99039246

(56) References cited:
- WO-A-96/12214
- WO-A-97/19969

## Description

### BACKGROUND OF THE INVENTION

The present invention relates to a process for producing a stable photoresist having very low particle counts, a substantially reduced tendency to produce additional particles, and a substantially stable photospeed. As manufacturing processes have evolved to produce finer geometries, the presence of particles in photoresist has become more of a problem.

Photoresist compositions are used in microlithography processes for making miniaturized electronic components such as in the fabrication of computer chips and integrated circuits. Generally, in these processes, a thin coating of film of a photoresist composition is first applied to a substrate material, such as a silicon. The coated substrate is then baked to substantially evaporate the solvent in the photoresist composition and to fix the coating onto the substrate. The baked coated surface of the substrate is next subjected to an image-wise exposure to radiation.

There are two types of photoresist compositions, negative-working and positive-working. When negative-working photoresist compositions are exposed image-wise to radiation, the areas of the resist composition exposed to the radiation become less soluble to a developer solution (e.g. a cross-linking reaction occurs) while the unexposed areas of the photoresist coating remain relatively soluble to such a solution. Thus, treatment of an exposed negative-working resist with a developer causes removal of the non-exposed areas of the photoresist coating and the creation of a negative image in the coating. Thereby uncovering a desired portion of the underlying substrate surface on which the photoresist composition was deposited.

On the other hand, when positive-working photoresist compositions are exposed image-wise to radiation, those areas of the photoresist composition exposed to the radiation become more soluble to the developer solution (e.g. a rearrangement reaction occurs) while those areas not exposed remain relatively insoluble to the developer solution. Thus, treatment of an exposed positive-working photoresist with the developer causes removal of the exposed areas of the coating and the creation of a positive image in the photoresist coating. Again, a desired portion of the underlying substrate surface is uncovered.

After this development operation, now partially unprotected substrate may be treated with a substrate-etchant solution or plasma gases and the like. The etchant solution or plasma gases etch that portion of the substrate where the photoresist coating was removed during development. The areas of the substrate where the photoresist coating still remains are protected and, thus, an etched pattern is created in the substrate material which corresponds to the photomask used for the image-wise exposure of the radiation. Later, the remaining areas of the photoresist coating may be removed during a stripping operation, leaving a clean etched substrate surface. In some instances, it is desirable to heat treat the remaining photoresist layer, after the development step and before the etching step, to increase its adhesion to the underlying substrate and its resistance to etching solutions.

Positive working photoresist compositions are currently favored over negative working resists because the former generally have better resolution capabilities and pattern transfer characteristics. Photoresist resolution is defined as the smallest feature which the resist composition can transfer from the photomask to the substrate with a high degree of image edge acuity after exposure and development. In many manufacturing applications today, resist resolution on the order of less than one micron are necessary. In addition, it is almost always desirable that the developed photoresist wall profiles be near vertical relative to the substrate. Such demarcations between developed and undeveloped areas of the resist coating translate into accurate pattern transfer of the mask image onto the substrate.

This radiation exposure causes a chemical transformation in the exposed areas of the coated surface. Visible light, ultraviolet (UV) light, electron beam and X-ray radiant energy are radiation types commonly used today in microlithographic processes. After this image-wise exposure, the coated substrate is treated with a developer solution to dissolve and remove either the radiation-exposed or the unexposed areas of the coated surface of the substrate.

Particle generation in the photoresist composition is a serious problem in coating a photoresist on the wafer. Photoresist compositions are formulated by dissolving a photosensitive compound, such as a 1,2-quinonediazide compound, and a film forming resin, such as a novolak resin in a photoresist solvent and filtering the resulting solution. Even after filtering very often some impurities remain in the solution and when the solution is stored for a long period of time (aged), some particles precipitate out of the solution. The particles accumulate over time and can be as large as 0.5 µm (micrometers) or larger. In order to achieve improved resolution and better yield in producing electronic devices, the number of particles have to be reduced to a very minimum level. As electronic device, such as computer chips, have become more sophisticated, problems caused by particles in the photoresist have become much more difficult to overcome.

Film forming novolak resins or polyvinyl phenols are frequently used as a polymeric binder in liquid photoresist formulations. Film forming novolak resins are typically produced by a condensation reaction between formaldehyde and one or more multi-substituted phenols, in the presence of an acid catalyst, such as oxalic acid or maleic anhydride.

### SUMMARY OF THE INVENTION

The present invention relates to a process for producing photoresist compositions having a very low level of particles, a substantially reduced tendency to produce additional particles, and a substantially stable photospeed. The present invention provides a process for producing such a photoresist composition by treating a photoresist composition with an acidic cation exchange resin at a temperature of from about 35°C to about 90°C, preferably for from about 1 to 15 hours, more preferably for from about 2 to about 12 hours, most preferably from about 4 to about 12 hours, thereby reducing the number of particles, reducing the generation of additional particles upon aging of the photoresist, and providing a substantially stable photospeed.

Alternatively, to produce such a photoresist composition, a photosensitive compound is filtered, treated with a cation exchange resin and then an anion exchange resin, and again filtered; a photoresist composition is then formulated by adding this treated photosensitive compound to a film forming resin, such as a novolak resin, and a suitable photoresist solvent. The photoresist composition is then treated as in the above process. The treatment of the photosensitive compound with exchange resins removes any excess amines (used to catalyze the production of photosensitive compounds), acids, and diazo chlorides which, if present, can lead to the formation of particles.

The process of the subject invention provides a substantially stable photoresist compositions which contains a film forming resin, such as a novolak resin obtained by condensing a mixture of methyl phenols and formaldehyde in a solvent, in the presence of an acid catalyst. After the condensation, the novolak resin is isolated, such as by a distillation process, to remove water, unreacted formaldehyde, unreacted methyl phenols and the solvent. A suitable amount of such a novolak resin and an effective amount of at least one photosensitive compound, which is normally obtained from the reaction of one or more 1,2-quinonediazide compounds and one or more phenolic compounds, are mixed in a suitable photoresist solvent to provide a photoresist composition.

The detailed mechanism or reaction that occurs during such heating of the photoresist compositions with an acidic cation exchange is unknown, but it is believed that some intermediate diazonium compounds may be present in the photoresist composition. These intermediates may react with other components of the photoresist composition over a period of time and accumulate to form particles. These may act as seeds for further formation and precipitation of particles. As a result of such accumulation of particles, even more and bigger particles are produced. The acidic cation exchange resin may act as a catalyst to convert all these intermediates under heat to more particles. Once such a photoresist composition is filtered, no more seeds remain to facilitate further formation of particles.

In the processes of the present invention, the temperature for heating the photoresist composition must be greater than room temperature (20°C to 25°C), i.e. from about 35°C to 90°C, preferably from about 40°C to 60°C and most preferably from about 40°C to 50°C. After heating, the mixture is preferably allowed to cool to 30°C or below, preferably to room temperature. When photoresist compositions are treated with a basic anion exchange resin at room temperature without heating, neither substantial reduction of particles nor substantial stabilization of photospeed is achieved.

The present invention provides a process for producing a photoresist composition having a very low level of particles, a very low tendency to produce additional particles, and a substantial stabilization of photospeed. The process for producing such a photoresist utilizes an acidic cation exchange resin which is heated with the photoresist composition and then filtered. The subject process comprises:
a) mixing a film forming resin, such as a novolak resin, with a photoactive compound, in a photoresist solvent, to provide a photoresist composition;
b) filtering the photoresist composition resulting from step a) through a filter having a rating of from about 0.05 µm to about 0.50 µm, preferably from about 0.05 µm to about 0.30 µm, most preferably from about 0.05 µm to about 0.15 µm;
c) treating the photoresist composition resulting from step b) with an acidic cation exchange resin and heating the photoresist composition to a temperature of from about 35°C to about 90°C, preferably from about 40°C to about 60°C, most preferably from about 40°C to about 50°C, preferably for from about 1 to about 15 hours; and
d) filtering the photoresist composition resulting from step c) through a filter having a rating of from about 0.05 µm to about 0.50 µm, preferably from about 0.05 µm to about 0.30 µm, most preferably from about 0.05 µm to about 0.15 µm.

In step c) the photoresist composition may be: 1) simultaneously treated with the acidic cation exchange resin and heated to a temperature of from about 35°C to about 90°C, or 2) first treated with the acidic cation exchange resin and then heated to a temperature of from about 35°C to about 90°C.

The invention further provides a method for producing the photoresist composition resulting from step a) of the above process by:
a) providing a photosensitive compound in a suitable solvent, such as tetrahydrofuran (THF), acetone, propylene glycol methyl ether (PGME) or a suitable photoresist solvent, such as ethyl lactate or propylene glycol methyl ether acetate (PGMEA);
b) treating the photosensitive compound resulting from step a) with an acidic cation exchange resin;
c) treating the photosensitive compound resulting from step b) with a basic anion exchange resin;
d) mixing a film forming resin, such as a novolak resin, with the photosensitive compound resulting from step c), in a photoresist solvent to provide a photoresist composition;
e) filtering the photoresist composition resulting from step d) through a filter having a rating of from about 0.05 µm to about 0.50 µm, preferably from about 0.05 µm to about 0.30 µm, most preferably from about 0.05 µm to about 0.15 µm;
f) heating the photoresist composition resulting from step e) with an acidic cation exchange resin at a temperature of from about 35°C to about 90°C, preferably from about 40°C to about 60°C, most preferably from about 40°C to about 50°C, preferably for from about 1 to about 15 hours;
g) filtering the photoresist composition resulting from step f) through a filter having a rating of from about 0.05 µm to about 0.50 µm, preferably from about 0.05 µm to about 0.30 µm, most preferably from about 0.05 µm to about 0.15 µm.
When the solvent for the photosensitive compound in step a) is different from the photoresist solvent used in step d), the solvent used in step a) is preferably substantially removed, such as by distillation or crystallization from water, after step c) and prior to step d).

An acidic cation exchange resin, such as a styrene/divinylbenzene cation exchange resin is utilized in the present process. Such ion exchange resins are available from Rohm and Haas Company, e.g. Amberlyst® 15 cation exchange resin. Basic anion exchange resins utilized in the process of the present invention include Amberlyst® 21, Amberlyst® 26 or Amberlyst® 27 anion exchange resins. These resins typically contain as much as 80,000 to 200,000 ppb of sodium and iron. Before being utilized in the process of the invention, the level of metal ions must be substantially reduced.

The acidic cation exchange resin should be rinsed with water and then a mineral acid solution. Preferably the cation exchange resin is initially rinsed with deionized water, followed by a mineral acid solution, such as a 10 percent sulfuric acid solution, rinsed again with deionized water, treated again with the mineral acid solution and once more rinsed with deionized water.

The anion exchange resin should be rinsed with water and then a non-metallic base solution. Preferably the anion exchange is initially rinsed with deionized water, followed by rinsing with a non-metallic base solution, such as 10% ammonium hydroxide, and rinsed again with deionized water, rinsed again with a non-metallic base solution, and once more rinsed with deionized.

Photoresist composition are formed by providing an admixture of a photosensitive compound; a film forming resin, such as a novolak resin or a polyvinyl phenol; and a suitable photoresist solvent. Suitable solvents for such photoresists may include propylene glycol mono-alkyl ether, propylene glycol alkyl (e.g. methyl) ether acetate, ethyl-3-ethoxypropionate, ethyl lactate, mixtures of ethyl-3-ethoxypropionate and ethyl lactate, 2-heptanone, 3-methyl-3-methyoxy-butanol (MMB), butyl acetate, xylene, diglyme, ethylene glycol monoethyl ether acetate. The preferred solvents are propylene glycol methyl ether acetate (PGMEA), ethyl lactate, 2-heptanone and ethyl-3-ethoxypropionate (EEP).

Other optional ingredients such as colorants, dyes, anti-striation agents, leveling agents, plasticizers, adhesion promoters, speed enhancers, solvents and such surfactants as non-ionic surfactants may be added to the solution of novolak resin, photosensitizer and photoresist solvent before the photoresist composition is coated onto a suitable substrate. Examples of dye additives that may be used together with the photoresist compositions of the present invention include Methyl Violet 2B (C.I. No. 42535), Crystal Violet (C.I. 42555). Malachite Green (C.I. No. 42000), Victoria Blue B (C.I. No. 44045) and Neutral Red (C.I. No. 50040) at 0.1 to 10 percent weight levels, based on the combined weight of PHS and sensitizer. The dye additives help provide increased resolution by inhibiting back scattering of light off the substrate.

Anti-striation agents may be used at up to about a five percent weight level, based on the combined weight of novolak and sensitizer. Plasticizers which may be used include, for example, phosphoric acid tri-(betachloroethyl)-ester; stearic acid; dicamphor; polypropylene; acetal resins; phenoxy resins; and alkyl resins, at about one to ten percent weight levels, based on the combined weight of novotak and sensitizer. The plasticizer additives improve the coating properties of the material and enable the application of a film that is smooth and of uniform thickness to the substrate.

Adhesion promoters which may be used include, for example, beta(3,4-epoxy-cyclohexyl)-ethyltrimethoxysilane; p-methyl-disilane-methyl methacrylate; vinyltrichlorosilane; and gamma-amino-propyl triethoxysilane up to about a 4 percent weight level, based on the combined weight of novolak and sensitizer. Development speed enhancers that may be used include, for example, picric acid, nicotinic acid or nitrocinnamic acid up to about a 20 percent weight level, based on the combined weight of novolak and sensitizer. These enhancers tend to increase the solubility of the photoresist coating in both the exposed and unexposed areas, and thus they are used in applications when speed of development is the overriding consideration even though some degree of contrast may be sacrificed; i.e., while the exposed areas of the photoresist coating will be dissolved more quickly by the developer, the speed enhancers will also cause a larger loss of photoresist coating from the unexposed areas.

The solvents may be present in the overall composition in an amount of up to 95% by weight of the solids in the composition. Solvents, of course are substantially removed after coating of the photoresist solution on a substrate and drying. Non-ionic surfactants that may be used include, for example, nonylphenoxy poly(ethyleneoxy) ethanol; octylphenoxy ethanol at up to about 10% weight levels, based on the combined weight of novolak and sensitizer.

The prepared photoresist solution, can be applied to a substrate by any conventional method used in the photoresist art, including dipping, spraying, whirling and spin coating. When spin coating, for example, the resist solution can be adjusted with respect to the percentage of solids content, in order to provide coating of the desired thickness, given the type of spinning equipment utilized and the amount of time allowed for the spinning process. Suitable substrates include silicon, aluminum, polymeric resins, silicon dioxide, doped silicon dioxide, silicon nitride, tantalum, copper, polysilicon, ceramics, aluminum/copper mixtures; gallium arsenide and other such Group III/V compounds.

The photoresist coatings produced by the described procedure are particularly suitable for application to thermally grown silicon/silicon dioxide-coated wafers, such as are utilized in the production of microprocessors and other miniaturized integrated circuit components. An aluminum/aluminum oxide wafer can also be used. The substrate may also comprise various polymeric resins, especially transparent polymers such as polyesters. The substrate may have an adhesion promoted layer of a suitable composition, such as one containing hexa-alkyl disilazane.

The photoresist composition solution is then coated onto the substrate, and the substrate is treated at a temperature from about 70°C to about 120°C for from about 30 seconds to about 180 seconds on a hot plate or for from about 15 to about 90 minutes in a convection oven. This temperature treatment is selected in order to reduce the concentration of residual solvents in the photoresist, while not causing substantial thermal degradation of the photosensitizer. In general, one desires to minimize the concentration of solvents and this first temperature treatment is conducted until substantially all of the solvents have evaporated and a thin coating of photoresist composition, on the order of one micron in thickness, remains on the substrate. In a preferred embodiment the temperature is from about 85°C to about 95°C. The treatment is conducted until the rate of change of solvent removal becomes relatively insignificant. The temperature and time selection depends on the photoresist properties desired by the user, as well as the equipment used and commercially desired coating times. The coating substrate can then be exposed to actinic radiation, e.g., ultraviolet radiation, at a wavelength of from about 300 nm to about 450 nm, x-ray, electron beam, ion beam or laser radiation, in any desired pattern, produced by use of suitable masks, negatives, stencils, templates, etc.

The photoresist coating is then optionally subjected to a post exposure second baking or heat treatment either before or after development. The heating temperatures may range from about 90°C to about 120°C, more preferably from about 100°C to about 110°C. The heating may be conducted for from about 30 seconds to about 2 minutes, more preferably from about 60 seconds to about 90 seconds on a hot plate or about 30 to about 45 minutes by convection oven.

The exposed photoresist-coated substrates are developed to remove the image-wise exposed areas by immersion in an alkaline developing solution or developed by spray development process. The solution is preferably agitated, for example, by nitrogen burst agitation. The substrates are allowed to remain in the developer until all, or substantially all, of the photoresist coating has dissolved from the exposed areas. Developers may include aqueous solutions of ammonium or alkali metal hydroxides. One preferred hydroxide is tetramethyl ammonium hydroxide. After removal of the coated wafers from the developing solution, one may conduct an optional post-development heat treatment or bake to increase the coating's adhesion and chemical resistance to etching solutions and other substances. The post-development heat treatment can comprise the oven or hotplate baking of the coating and substrate below the coating's softening point. In industrial applications, particularly in the manufacture of microcircuitry units on silicon/silicon dioxide-type substrates, the developed substrates may be treated with a buffered, hydrofluoric acid base etching solution. The photoresist compositions of the present invention are resistant to acid-base etching solutions and provide effective protection for the unexposed photoresist-coating areas of the substrate.

The following specific examples will provide detailed illustrations of the methods of producing and utilizing compositions produced by the process of the present invention. These examples are not intended, however, to limit or restrict the scope of the invention in any way and should not be construed as providing conditions, parameters or values which must be utilized exclusively in order to practice the present invention.

### Example 1

Amberlyst® 15 (A-15) acidic cation exchange resin beads were cleaned by rinsing with deionized (Dl) water and then 10% hydrochloric acid solution in water. The pre-cleaned beads were then wet with Dl water, then rinsed thoroughly with methanol (MeOH) and then with propylene glycol methyl ether (PGME). The resulting beads were then added into AZ® 7518 photoresist (available from AZ Electronic Materials, Clariant Corp.) in a 4-neck round bottom flask, equipped with a heating mantle, a thermometer, a thermowatch, a condenser and a mechanical stirring rod & blade. A dark red mixture resulted, which was heated to 50°C and kept at that temperature for 6 hours. After the heating mantle was removed, stirring was continued until the temperature of the mixture was 30°C. The mixture was allowed to sit overnight. The resulting photoresist was filtered into a pre-cleaned & metal ion free 500 ml amber glass bottle, using a Zeta Plus® B0204-30CP cartridge and a 0.2 µm (micrometer) Gelman® filter under compressed N₂ pressure. The treated photoresist was then force aged for different times at a temperature of 40°C. The number of particles 0.5 µm or larger and 0.3 µm or larger was counted using an automated particle counter. The results are shown in Table 1 below.

**Table 1**

| **Example** **#** | **Process** | **Forced Aging Conditions** | **0.5µm** **Particles /ml** | **0.3µm** **Particles/ml** |
|---|---|---|---|---|
| 1 | 5% A-15, 50°C, 6 hrs.; filtered through 0.2µm filter | Solution as is | 47 | 309 |
| | | 40°C, 1 day | 18 | 125 |
| | | 40°C, 7 days | 50 | 210 |

### Example 2

Example 1 was repeated using 3% by weight of A-15 at 50°C for 4 hours. The resulting mixture was then filtered, as in Example 1, and was forced aged as in Example 1, under conditions listed below in Table 2. The LPC (liquid particles count) is also shown in Table 2.

**Table 2**

| **Example** **#** | **Process** | **Forced Aging Conditions** | **0.5µm** **Particles/ml** | **0.3µm** **Particles/ml** |
|---|---|---|---|---|
| 2 | 3% A-15, 50°C, 4 hrs.; filtered through 0.2 µm filter | Solution as is | 44 | 404 |
| | | 40°C, 1 day | 86 | 565 |
| | | 40°C, 3 days | 64 | 566 |
| | | 40°C, 7 days | 53 | 796 |

### Example 3

Samples of the photoresist from example 1, example 2, and comparative example 4 were coated on a hexamethyldisilazane (HMDS) primed silicon wafers to a 1.7 µm film thickness. Subsequently a soft bake at 110°C for 60 seconds on an SVG® 8100 l-line hot plate was used. The exposure matrix was printed on the coated wafers using a 0.54 NA NIKON® i-line stepper and a NIKON® resolution reticle. The exposed wafers were post exposure baked at 110°C for 60 seconds on an in-line hot plate. The wafers were then developed using AZ® 300 MIF TMAH developer (2.38% tetramethyl ammonium hydroxide by weight in water - available from AZ Electronic Materials, Clariant Corp.). The developed wafers were examined using a HITACHI® S-400 scanning electron microscope (SEM). A nominal DTP (dose to print - the dose required to precisely replicate a given feature), resolution, exposure latitude, and focus latitude were measured at the best focus. The test results are shown in Table 3 below. All these three photoresist samples were stored in a thermostat for 7 days (force aged) at 40°C and the photospeeds were measured again and compared with unaged samples, to determine the stability in terms of photospeed. The results are shown in Table 3 below.

**Table 3**

| **Samples from Example #** | **Resolution (µm)** | **Exposure Latitude (%)** | **Focus Latitude (µm)** | **Dose to print (Mj/cm**^{**2**}**)** | **Aging stability (Photospeed %)** |
|---|---|---|---|---|---|
| 1 | 0.55 | 25 | 1.6 | 143 | -1.0 |
| 2 | 0.55 | 23 | 1.6 | 163 | -0.9 |
| 4 | 0.55 | 31 | 1.6 | 146 | -10.6 |

The samples from example 1 and 2 were very stable in terms of particles, additional particle generation and photospeed. The sample from example 4 was unstable in terms of particles, particle generation and photospeed.

### Comparative Example 4

Example 1 was repeated with 5% A-15 at room temperature for 6 hours and the mixture was filtered, as in Example 1, through a 0.1 µm filter. The resulting photoresist was then forced aged, as in Example 1, under the conditions listed below in Table 4. Under these condition, the number of particles was very high after 7 days forced aging. This example indicates that heating of the photoresist is essential.

**Table 4**

| **Example** | **Process** | **Forced Aging Conditions** | **0.5µm Particles/ml** | **0.3µm Particles/ml** |
|---|---|---|---|---|
| Comparative 4 | 5% A-15, rm. Temp. 6hrs. and filtered through 0.2 µm filter | Solution as is | 18 | 94 |
| | | 40°C, 1 day | 29 | 96 |
| | | 40°C, 3 days | 101 | 421 |
| | | 40°C, 7 days | 32,504 | 50,551 |

### Comparative Example 5

AZ® 7518 photoresist (available from AZ Electronic Materials, Clariant Corp.) was filtered through a Zeta Plus® B0204-30CP cartridge and a 0.2 µm Gelman® filter, under compressed N₂ pressure. The photoresist was then forced aged, as in Example 1, under the conditions listed below in Table 5. Particles were then measured and the LPC results are also shown in Table 5. This example shows that only filtration to remove those particles is not good enough to make photoresist composition stable.

**Table 5**

| **Example** | **Process** | **Forced Aging Conditions** | **0.5 µm Particles/ml** | **0.3 µm Particles/ml** |
|---|---|---|---|---|
| Comparative 5 | Filtered through 0.2 µm filter | Solution as is | 45 | 246 |
| | | 40°C, 1 day | 84 | 324 |
| | | 40°C, 3 days | 407 | 157989 |
| | | 40°C, 7 days | 4572 | 108652 |

### Comparative Example 6

AZ® 7518 photoresist (available from AZ Electronic Materials, Clariant Corp.) was placed in a 4-neck round bottom flask, equipped with a heating mantle, a thermometer, a thermowatch, a condenser and a mechanical stirring rod & blade. The photoresist was then heated to 50°C and kept at this temperature for 6 hours. After heating for 6 hours, heating mantle was removed. Stirring was continued until the temperature of the mixture was back to 30°C. The mixture was allowed to sit overnight. The resulting photoresist was filtered into pre-cleaned & metal free 500 ml amber glass bottle, through a Zeta Plus® B0204-30CP cartridge and a 0.2 µm Gelman® filter under compressed N₂ pressure. The treated photoresist was stored in a thermostat for different times (force aged) at 40°C. The number of particles was measured at both 0.5 µm and larger and at 0.3 µm using the automated particle counter. The results are also shown in Table 6 below.

**Table 6**

| **Example** | **Process** | **Forced Aging Conditions** | **0.5 µm** **Particles/ml** | **0.3 µm** **Particles/ml** |
|---|---|---|---|---|
| Comparative 6 | Heated for 6 hours at 50°C and Filtered through 0.2 µm | Solution as is | 1 | 236 |
| | | 40°C, 1 day | >100000 | >100000 |
| | | 40°C, 3 days | >100000 | >100000 |

### Comparative Example 7

A-15 ion exchange resin beads were washed with 5 bed volumes of 10% HCI solution. A large amount of DI water was used to rinse the A-15 beads reached until the conductivity of the rinse water no longer decreased. Amberlyst® 21 (A-21) basic anion exchange resin beads were pre-cleaned by rinsing with deionized, then with 10% ammonium hydroxide, and again with deionized water. The A-15 and A-21 beads were each then put into separate columns and rinsed with 3 bed volumes each of MeOH followed by rinsing with PGMEA. IBM® 7518 photoresist (available from IBM) was filtered through a Zeta Plus® B0204-30CP cartridge and a 0.2 µm Gelman® filter under compressed N₂ pressure, and then passed through the prepared A-15 column followed by passing through the A-21 column. The retention time in each column was 15 minutes. The resulting photoresist was filtered, as in Example 1, into a pre-cleaned & metal free 500 ml amber glass bottle, through a Zeta Plus® B0204-30CP cartridge and a 0.2 µm Gelman® filter under compressed N₂ pressure. The photoresist was then forced aged, as in Example 1, under the condition listed in Table 7, below. Particles were then measured and the LPC results are also shown in Table 7.

**Table 7**

| **Example** | **Process** | **Forced Aging Conditions** | **0.5 µm Particles/ml** | **0.3µm Particles/ml** |
|---|---|---|---|---|
| Comparative 7 | Filtered through 0.2 µm filter; passed through A-15 & A-21; filtered through 0.2 µm filter | Solution as is | 32 | 17,370 |
| | | 40°C, 1 day | 924 | 28,627 |

### Comparative Example 8

AZ® 7518 photoresist (available from AZ Electronic Materials, Clariant Corp.) and glacial acetic acid (1% of the weight of the photoresist) were placed in a 4-neck round bottom flask, equipped with a heating mantle, a thermometer, a thermowatch, a condenser and a mechanical stirring rod & a blade. The photoresist was then heated to 50°C and kept at this temperature for 6 hours. After 6 hours of heating, the heating mantle was removed and the stirring was continued until the temperature of the mixture was back to 30°C. The mixture was then allowed to sit overnight. The resulting photoresist was filtered, as in Example 1, into a pre-cleaned and metal free 500 ml amber glass bottle, through a Zeta Plus® B0204-30CP cartridge and 0.2 µm Gelman® filter, under compressed N₂ pressure. The treated photoresist then stored in a thermostat for different times (force aged) at 40°C. The number of particles 0.5 µm and larger, and 0.3 µm and larger were counted using the automated particle counter. The results are shown in Table 8 below.

**Table 8**

| **Example** | **Process** | **Forced Aging Conditions** | **0.5 µm Particles/ml** | **0.3 µm Particles/ml** |
|---|---|---|---|---|
| Comparative 8 | Heated for 6 hours at 50°C with 1% glacial acetic acid and filtered through 0.2 µm filter | Solution as is | >100000 | >100000 |
| | | 40°C, 1 day | >100000 | >100000 |
| | | 40°C, 3 days | >100000 | >100000 |

### Comparative Example 9

### Preparation of Photoresist

2000 ml of a 15% solution of PW-994 photosensitive compound [diazo-2,1,5- and 2,1,4- diazonaphthoquinone sulfonate ester of tris-1,1,1-(4 hydroxyphenyl) ethane] in PGMEA was prepared. The resulting solution was first filtered through Whatman #4 filter paper and less than 1% of the photosensitive compound (PAC) was lost. The solution was then filtered through a 0.10 µm filter. Two 600 ml columns were prepared, one containing Amberlyst® 15 acidic cation exchange resin which had been rinsed with deionized water, a 10% sulfuric acid solution and again with deionized water. The other column contained Ambertyst® 21 basic anion exchange resin was rinsed with deionized water, a 10% ammonium hydroxide solution and again with deionized water. Both columns were rinsed with PGMEA and blown dry. The PAC solution was passed through the Amberlyst® 15 cation exchange resin column at a flow rate of about 75 ml per minute. The PAC solution was then passed through the Amberlyst® 21 anion exchange resin column at about the same flow rate. The PAC solution was then adjusted to the correct solids level by viscosity measurement to a 11.0 centistokes target. To 1200 grams of the PAC solution in PGMEA was added 1200 grams of a 40% solution of novolak resin 72 (a film forming phenol formaldehyde novolak resin available from AZ Electronic Materials, Clariant Corp.) and FC-430 fluorinated surfactant (available from 3M) in a ratio of novolak/surfactant of 1.0/.0007. The mixture was then well mixed, and the viscosity and absorbance rates were adjusted appropriately to the 11.0 centistokes target and bulk absorbance at 360 nanometers of 0.87 to produce a photoresist composition. The photoresist composition was then treated by passing the composition through the Ambertyst® 21 anion exchange column, heat treating the photoresist for about 12 hours at 45°C, and then filtering the heat treated composition through a 0.10 µm filter. The photoresist composition was then aged at 40°C for the time periods shown in Table 9 below. LPD data is also shown in Table 9.

**Table 9**

| LPC data for AZ® 7511 photoresist (available from AZ Electronic Materials, Clariant Corp.) aged with PAC/PGMEA solution with either no aging or aging for 3 days (0.3 micron particles/ml) | | |
|---|---|---|
| TIME* | NEW | NEW/AGED |
| 0 | 6166 | 5731 |
| 1 | 8221 | 7404 |
| 4 | 10528 | 5148 |
| 7 | 8013 | 73786 |

| | | |
|---|---|---|
| TIME* = Time, in days, the resist was held at 50°C NEW = Lab prepared AZ® 7511 resist using the present process, and no PAC solution aging NEW/AGED = Lab prepared AZ® 7511 resist using the present process, using PAC solution held at room temperature for 3 days prior to aging. | | |

## Claims

1. A process for producing a low particle containing and low particle generating photoresist composition comprising:
a) mixing a film forming resin with a photosensitive compound, in a photoresist solvent, and thereby providing a photoresist composition;
b) filtering the photoresist composition resulting from step a) through a filter having a rating of from about 0.05 µm to about 0.50 µm;
c) treating the photoresist composition resulting from step b) with an acidic cation exchange resin and heating the photoresist composition to a temperature of from about 35°C to about 90°C; and
d) filtering the photoresist composition resulting from step c) through a filter having a rating of from about 0.05 µm to about 0.50 µm.

2. The process of claim 1, wherein in step c), said photoresist composition is simultaneously treated with said cation exchange resin and heated to a temperature of from about 35°C to about 90°C.

3. The process of claim 1, wherein in step c), said photoresist composition is first treated with said cation exchange resin and then heated to a temperature of from about 35°C to about 90°C.

4. The process of claim 1, wherein the temperature in step c) is from about 40°C to 60°C.

5. The process of claim 1, wherein the temperature in step c) is from about 40°C to about 50°C.

6. The process of claim 1, wherein the filter in steps b) and d) has a rating of from about 0.05 µm to about 0.30 µm.

7. The process of claim 1, wherein the filter in steps b) and d) has a rating of from about 0.05 µm to about 0.15 µm.

8. The process of claim 1, wherein in step a) the film forming resin is a novolak resin.

9. The process of claims 1, 2, 3, 4, 5, 6, 7 or 8, wherein the photoresist composition resulting from step a) is produced by:
i) providing a solution of a photosensitive compound in a suitable solvent;
ii) treating the photosensitive compound solution resulting from step i) with an acidic cation exchange resin;
iii) treating the photosensitive compound solution resulting from step ii) with a basic anion exchange resin;
iv) mixing a film forming resin with the photosensitive compound solution resulting from step iii), in a photoresist solvent, and thereby providing a photoresist composition.

10. The process of claim 9, wherein the solvent in step i) is different from the solvent in step iv) and wherein, prior to step iv), the solvent from step i) is substantially removed from the photosensitive compound solution resulting from step iii).

## Patentansprüche

1. Verfahren zur Herstellung einer Photoresistzubereitung mit niedrigem Teilchengehalt und geringer Tendenz zur Teilchenbildung, das aus folgenden Schritten besteht:
a) Mischen eines filmbildenden Harzes mit einer lichtempfindlichen Verbindung in einem Photoresistlösungsmittel zur Herstellung einer Photoresistzubereitung;
b) Filtrieren der Photoresistzubereitung aus Schritt a) über ein Filter mit ca. 0,05 µm bis ca. 0,50 µm Porenweite;
c) Behandeln der Photoresistzubereitung aus Schritt b) mit einem sauren Kationenaustauscherharz und Erwärmen der Photoresistzubereitung auf ca. 35°C bis ca. 90°C und
d) Filtrieren der Photoresistzubereitung aus Schritt c) über ein Filter mit ca. 0,05 µm bis ca. 0,50 µm Porenweite.

2. Verfahren gemäß Anspruch 1, wobei die genannte Photoresistzubereitung in Schritt c) mit dem genannten Kationenaustauscherharz behandelt und gleichzeitig auf ca. 35°C bis ca. 90°C erwärmt wird.

3. Verfahren gemäß Anspruch 1, wobei die genannte Photoresistzubereitung in Schritt c) zuerst mit dem genannten Kationenaustauscherharz behandelt und anschließend auf ca. 35°C bis ca. 90°C erwärmt wird.

4. Verfahren gemäß Anspruch 1, wobei die Temperatur in Schritt c) ca. 40°C bis 60°C beträgt.

5. Verfahren gemäß Anspruch 1, wobei die Temperatur in Schritt c) ca. 40°C bis ca. 50°C beträgt.

6. Verfahren gemäß Anspruch 1, wobei das Filter in Schritt b) und d) eine Porenweite von ca. 0,05 µm bis ca. 0,30 µm besitzt.

7. Verfahren gemäß Anspruch 1, wobei das Filter in Schritt b) und d) eine Porenweite von ca. 0,05 µm bis ca. 0,15 µm besitzt.

8. Verfahren gemäß Anspruch 1, wobei das filmbildende Harz in Schritt a) ein Novolakharz ist.

9. Verfahren gemäß Anspruch 1, 2, 3, 4, 5, 6, 7 oder 8, wobei die Photoresistzubereitung aus Schritt a) wie folgt hergestellt wird:
i) Herstellen einer Lösung einer lichtempfindlichen Verbindung in einem geeigneten Lösungsmittel;
ii) Behandeln der Lösung der lichtempfindlichen Verbindung aus Schritt i) mit einem sauren Kationenaustauscherharz;
iii) Behandeln der Lösung der lichtempfindlichen Verbindung aus Schritt ii) mit einem basischen Anionenaustauscherharz;
iv) Mischen eines filmbildenden Harzes mit der Lösung der lichtempfindlichen Verbindung aus Schritt iii) in einem Photoresistlösungsmittel, wobei eine Photoresistzubereitung entsteht.

10. Verfahren gemäß Anspruch 9, wobei in Schritt i) ein anderes Lösungsmittel verwendet wird als in Schritt iv) und wobei das Lösungsmittel aus Schritt i) vor Schritt iv) aus der in Schritt iii) hergestellten Lösung der lichtempfindlichen Verbindung weitgehend entfernt wird.

## Revendications

1. Procédé pour la production d'une composition de photoréserve contenant peu de particules et engendrant peu de particules, comprenant les étapes suivantes :
a) mélanger une résine filmogène avec un composé photosensible, dans un solvant de photoréserve, et obtenir ainsi une composition de photoréserve ;
b) filtrer la composition de photoréserve résultant de l'étape a) à travers un filtre ayant une ouverture d'environ 0,05 µm à environ 0,50 µm ;
c) traiter la composition de photoréserve résultant de l'étape b) avec une résine échangeuse de cations acide et chauffer la composition de photoréserve à une température d'environ 35°C à environ 90°C ; et
d) filtrer la composition de photoréserve résultant de l'étape c) à travers un filtre ayant une ouverture d'environ 0,05 µm à environ 0,50 µm.

2. Procédé selon la revendication 1, dans lequel, dans l'étape c), ladite composition de photoréserve est simultanément traitée avec ladite résine échangeuse de cations et chauffée à une température d'environ 35°C à environ 90°C.

3. Procédé selon la revendication 1, dans lequel, dans l'étape c), ladite composition de photoréserve est d'abord traitée avec ladite résine échangeuse de cations, puis chauffée à une température d'environ 35°C à environ 90°C.

4. Procédé selon la revendication 1, dans lequel la température dans l'étape c) est d'environ 40°C à 60°C.

5. Procédé selon la revendication 1, dans lequel la température dans l'étape c) est d'environ 40°C à environ 50°C.

6. Procédé selon la revendication 1, dans lequel le filtre, dans les étapes b) et d), a une ouverture d'environ 0,05 µm à environ 0,30 µm.

7. Procédé selon la revendication 1, dans lequel le filtre, dans les étapes b) et d), a une ouverture d'environ 0,05 µm à environ 0,15 µm.

8. Procédé selon la revendication 1, dans lequel, dans l'étape a), la résine filmogène est une résine novolaque.

9. Procédé selon les revendications 1, 2, 3, 4, 5, 6, 7 ou 8, dans lequel la composition de photoréserve résultant de l'étape a) est produite par les étapes suivantes :
i) préparer une solution d'un composé photosensible dans un solvant approprié ;
ii) traiter la solution de composé photosensible résultant de l'étape i) avec une résine échangeuse de cations acide ;
iii) traiter la solution de composé photosensible résultant de l'étape ii) avec une résine échangeuse d'anions basique ;
iv) mélanger une résine filmogène avec la solution de composé photosensible résultant de l'étape iii), dans un solvant de photoréserve, et obtenir ainsi une composition de photoréserve.

10. Procédé selon la revendication 9, dans lequel le solvant dans l'étape i) est différent du solvant dans l'étape iv) et dans lequel, avant l'étape iv), le solvant de l'étape i) est substantiellement éliminé de la solution de composé photosensible résultant de l'étape iii).
